(19) Europäisches Patentamt
European Patent Office
Office européen des brevets

(11) Publication number: **0 375 159 A1**

(12) **EUROPEAN PATENT APPLICATION**

(21) Application number: **89312105.3**

(22) Date of filing: **22.11.89**

(51) Int. Cl.5: **G03C 1/93, G03F 7/07**

(30) Priority: **15.12.88 US 284537**

(43) Date of publication of application: **27.06.90 Bulletin 90/26**

(84) Designated Contracting States: **BE DE GB IT**

(71) Applicant: **MINNESOTA MINING AND MANUFACTURING COMPANY**
**3M Center, P.O. Box 33427**
**Saint Paul, MN 55133- 3427(US)**

(72) Inventor: **Weeks, Michael G. c/o Minnesota Mining and Manufacturing Co. 2501 Hudson Road**
**St. Paul Minnesota 55144-1000(US)**

(74) Representative: **Baillie, Iain Cameron et al**
**c/o Ladas & Parry Isartorplatz 5**
**D-8000 München 2(DE)**

(54) **Improved adhesion of gelatin-based layers to subbed film base of silver salt diffusion transfer type lithoplates.**

(57) In silver salt diffusion transfer lithographic printing plates, the adhesion of gelatin-based layers to subbed film base is increased by incorporation of a defined polymer therein. Also, methods for making and printing with such printing plates.

EP 0 375 159 A1

# INCREASED ADHESION OF GELATIN-BASED LAYERS TO SUBBED FILM BASE OF SILVER SALT DIFFUSION TRANSFER TYPE LITHOPLATES

## Field of Invention

The present invention relates to improved adhesion of gelatin-based, i.e., gelatin-containing, layers to subbed film bases of silver salt diffusion transfer type lithoplates, and particularly relates to novel gelatin-based layers which attain increased adhesion to such film bases.

## Background

Lithographic printing plates consist of relatively oleophilic/hydrophobic or ink-receptive image areas and relatively oleophobic/hydrophilic non-image or background areas. Printing is carried out with such printing plates by applying both water and ink to the surface of the plate whereupon the image areas preferentially receive ink and the non-image areas preferentially receive water and then contacting the plate to a substrate such as a sheet of paper or offset blanket and transferring the ink thereto. Accordingly, in order to achieve high quality printing with such plates, the image and non-image areas should retain their respective oleophilicity and oleophobicity.

A typical construction of a lithographic printing plate of the silver salt diffusion transfer type, comprises film base, typically primed and subbed, an optional antihalation layer, silver halide-containing emulsion layer, and a receptor layer. In many instances, the subbing layer, antihalation layer, and/or emulsion layer may contain gelatin.

In silver salt diffusion transfer type plates, a radiation-sensitive emulsion contains silver salt grains which upon exposure will form a latent image that can then be reduced to black silver by development to form hydrophilic nonimage areas, while the unexposed silver salt crystals can be converted to soluble silver salt complexes by action of silver salt solvents, e.g., sodium thiosulphate or potassium thiocyanate, in the developer. Such developers are typically very alkaline in nature, i.e., typically having pH of about 13.0 or more. The dissolved silver salt complexes diffuse to a receptor layer or element which is in intimate contact with the emulsion layer, and are then developed, e.g., reduced to metallic silver by development nuclei or catalyst, thereby forming hydrophobic, i.e., oleophilic, image areas. The exposed silver does not diffuse into the receptor layer, leaving the associated areas of the receptor layer substantially devoid of silver and therefore substantially hydrophilic.

The use of polyester or other polymeric materials as film base or first layer has developed to provide several advantages relative to conventional metal base lithoplates, including, for example, transparency which enables exposure through the back side, typically lower cost, easier handling, easier processing, and increased flexibility. Some examples of other film base materials include polystyrene, polyalkyl acrylate or methacrylate, cellulose acetate, and coated papers. Such films may be optionally primed, e.g., with a chlorinated copolymer, aziridine and polyester composition, or corona treating, to improve adhesion of subsequent layers thereto. U.S. Patent No. 2,943,937 (Nadeau et al.) discloses a process for conditioning photographic bases made from oriented linear polyesters to increase the adhesion of subbing layers thereto wherein the base is subjected to the action of certain inorganic acidic or basic compositions which have an oxidizing effect upon the polyester film.

The next layer is the subbing layer which is typically a thin layer of gelatin or other hydrophilic material. U.S. Patent Nos. 3,495,984 (Vanpoecke et al.); 3,495,985 (De Keyser et al.); and 3,788,856 (Van Paesschen et al.) disclose subbing layers. U.S. Patent No. 4,132,552 (Van Paesschen et al.) discloses a primed polyester film with a subbing layer thereon. U.S. Patent No. 4,009,037 (Mann et al.) discloses the improvement of adhesion of a gelatin coating, e.g., a gelatin-type subbing layer, to a styrene homopolymer or copolymer film by solvent treating and corona discharge treating the film prior to coating the gelatin layer thereon.

Over the subbing layer, the next layer is typically an optional antihalation layer which serves to decrease light scattering. In some instances the antihalation layer may be disposed on the back side of the film base, i.e., the opposite side of the film base as the subbing layer and emulsion layer which is described below. An antihalation agent improves image quality by reducing diffuse scattering of light from the substrate, the other coated layers, or the various interfaces in the coated light-sensitive construction by absorbance of incident and reflected light. Typically, they include light-absorbing coated surfaces, binders, compounds, or dyes. Examples of materials used in such layers include triphenyl methane dyes (e.g., acid

fuchsine and crystal violet), carbon black, manganese dioxide, and colloidal silver. In some instances, light-absorbing materials may tend to interfere with desired interlayer adhesion between the antihalation layer and adjacent layers. For instance, carbon black is typically supplied commercially in the form of a dispersion which contains surfactants which may tend to interfere with the adhesion of the antihalation layer to adjacent layers.

Over the antihalation layer or subbing layer, depending upon the particular construction, there is a radiation-sensitive emulsion coating which typically comprises silver halide grains dispersed in gelatin or other hydrophilic colloidal material.

Finally, silver salt diffusion transfer type plates typically comprise a top coat over the radiation sensitive emulsion coating which serves as a receptor layer for development of the printing plate. An illustrative example of such receptor layers is disclosed in U.S. Patent No. 4,361,635 (Kinderman et al.). When the soluble silver salt complex contacts the development nuclei or catalyst typically contained in the receptor layer, the silver is reduced to an oleophilic metallic deposit.

As with conventional lithographic printing plates, the quality of the images reproduced by silver salt diffusion transfer type lithographic printing plates can be impaired if the plate does not possess desired dimensional stability properties or if some breakdown in the construction of the plate affects the image-wise differential hydrophilicity and hydrophobicity of the printing surface. For instance, poor adhesion between any of the layers of the plate may result in loss of a portion of the plate coatings such that an underlying portion of the plate is exposed which has different lithographic properties than did the original portion of the printing surface which is lost. Such poor adhesion and resultant image degradation typically results in shortened press life of the plate. Some conditions which may tend to cause loss of adhesion include chemical attack from exposure to harsh compositions or solutions, e.g., fountain solutions, cleaning solutions, developers, etc.; rough treatment during plate preparation and handling; and the stresses during printing, especially at high press speeds. For instance, diffusion transfer type developer solutions typically have pHs of about 13.0 or more. In some instances, loss of interlayer adhesion may result from, or be increased by, variations in the composition or characteristics of one or more of the layers of the printing plate. For instance, different lots of subbed polyester base have been observed to exhibit varying degrees of adhesive performance with conventional gelatin-based layers.

## Summary of Invention

The present invention provides novel silver salt diffusion transfer type lithographic printing plates comprising gelatin-based, i.e., gelatin-containing, layers which attain substantially improved adhesion to subbed film bases. Such improved adhesion is achieved by incorporation of an effective amount of a hereinafter defined stability-enhancing polymer or copolymer in a gelatin-based layer which is formed over the subbing layer. The present invention also provides a method for developing such printing plates and a method for printing with such printing plates.

In brief summary, one embodiment of a silver salt diffusion transfer (sometimes referred to hereinafter as "DT") type lithographic printing plate element of the invention comprises (1) a film support or base having at least one polymeric surface, typically primed, to which is adhered (2) a subbing layer, (3) a stability-enhanced gelatin-based layer (sometimes referred to hereinafter as "SEGBL"), optionally functioning as an antihalation layer, comprising an effective amount of a hereinafter defined polymer or copolymer (sometimes referred to herein as a Stability Enhancing Agent or "SEA"), and gelatin, mutually dispersed substantially uniformly, which is adhered over the subbing layer. In some embodiments the stability-enhanced gelatin-based layer may itself be a radiation-sensitive emulsion, and further comprise silver halide grains dispersed therein. In other embodiments, the element may further comprise an additional layer over the SEGBL which is a radiation-sensitive silver halide emulsion. Such embodiments may also further comprise an optional silver halide diffusion transfer receptor layer.

I have found that the novel printing plates provided herein unexpectedly achieve increased press life. This is believed to be the result of improved adhesion to the underlying prime or subbing, i.e., interlayer adhesion, attained by stability-enhanced gelatin-based layers described herein. The increased adhesion is believed to be achieved in part by increased dimensional stability and resistance to swelling and mechanical stresses imparted to the SEGBL by the stability-enhancing polymers or copolymers described herein. The SEGBLs provided herein are resistant to, and maintain high adhesion to underlying subbing layers, even in highly alkaline, e.g., pH of 13 or more, conditions such as are typically obtained with silver salt diffusion transfer developer solutions. Unexpectedly, the advantages of the present invention may be obtained when the SEAs discussed herein are incorporated in only one gelatin-based layer of a printing

plate element which comprises two or more gelatin-containing layers. For instance, if desired, such polymers or copolymers may be incorporated in a gelatin-containing antihalation layer over a subbing layer but not in the gelatin-containing radiation-sensitive emulsion which is over the antihalation layer while achieving the advantages of the present invention.

## Detailed Description of Invention

Silver salt diffusion transfer lithographic printing plates of the present invention will typically be made with subbed polyester base or support films. The polyester film is typically biaxially oriented. Such support films are commonly used for lithographic printing plates because of the high durability and dimensional stability which such supports impart relative to other non-metal lithographic film bases. High dimensional stability is important in many photographic applications, and is of particular advantage for printing plates used on large presses where substantial stresses are encountered which may tend to distort the plate, and thereby interfere with the accuracy and registration of the image which is printed.

Support film materials used in lithographic elements of the invention may contain opacifying agents such as pigments to reduce halation. If desired, they may be substantially transparent to the wavelength to which the radiation-sensitive emulsion is sensitized to permit exposure from behind the support film.

It will be understood that in some embodiments printing plates of the present invention may also be made with support films made from other materials, including any of the transparent or opaque supports commonly used in photographic elements. Some illustrative examples thereof include films of synthetic polymers such as polyalkyl acrylate or methacrylate, polystyrene, polyvinyl chloride, partial formulation polyvinyl alcohol, polycarbonate, and polyamides, films of cellulose acetate, cellulose triacetate, and cellulose acetate butyrate; papers covered with alpha-olefin polymers or gelatin; and synthetic papers made of polystyrene.

It is typically preferred that the support material be primed, e.g., by corona treatment and/or application of a prime coating thereto, to increase the adhesion thereto of the subbing layer. Examples of prime coatings, which are typically relatively more hydrophilic than the support material, include, but are not limited to, poly(vinylidene chloride) copolymers, aziridines, acrylates, melamine-formaldehyde, and aziridine and polyester compositions. Typically, such prime coatings are on the order of about 0.05 microns thick.

The subbing layer of printing plates of the invention is typically a thin layer comprising gelatin, one or more adhesion additives, and one or more hardening agents, e.g., chrome alum. Such subbing layers are typically on the order of about 0.2 microns thick, and relatively more hydrophilic than the prime or base material, and are coated on the surface of the typically primed support film by known techniques, e.g., knife coating, dip coating, roller coating, or slot coating, from aqueous or organic solvent solutions and then dried.

Another illustrative example of a subbing layer is a gelled network of inorganic particles, preferably oxides, containing an adhesion-promoting amount of an ambifunctional silane. By ambifunctional silane it is meant that the compound has reactive silanes on one end of the molecule and a different reactive species capable of reacting with a photographic hardener for gelatin or directly with gelatin. This second functionality enables the compound to react with the inorganic particles (through the silane group) and also with the gelatin (by reacting with the gelatin hardener which also reacts with the gelatin). Among the preferred second functional groups on the compound are amino groups and epoxy (e.g., glycidyl) groups. The second functionality may be present as a single functional moiety or may be present as a multiple number of such groups. European Patent Application No. 88.306918, "Photographic Element With Novel Subbing Layer" by Van Oiij et al. and commonly assigned herewith, discloses such subbing layers. The teachings of that reference are disclosed herein by reference.

Some of the types of gelatin useful in the present invention for use in the stability-enhanced gelatin-based layer which is adhered to the subbing layer and typically for any other layer of printing plate elements of the invention wherein gelatin is used, e.g., in some embodiments the prime layer and/or subbing layer, or the radiation-sensitive emulsion or optional top coat described below, include, but are not limited to, lime treated gelatin, acid treated gelatin, and deionized gelatin.

According to the present invention, improved adhesion of gelatin-based layers, e.g., antihalation or radiation-sensitive emulsion layers, to the subbing layer may be achieved by incorporation into the gelatin-based layer of an effective amount of a stability enhancing polymer or copolymer, i.e., SEA, having the following formula:

$$-(CH_2-\underset{R^1}{\overset{R^2}{C}})_n- ,$$ (Formula I)

wherein $R^1$ is a hydrogen or methyl; and $R^2$ is a nitrilo, i.e., -CN, or group having the formula:

$$-\overset{O}{\overset{\|}{C}}-O-R^3,$$ (Formula II)

wherein $R^3$ is a hydrogen or an alkyl having from 1 to 4 carbon atoms. The $R^1$, $R^2$, and $R^3$ groups of different repeating units may be variously selected from the classes just described, i.e., the SEA may be a copolymer. Examples of useful polymers and copolymers include, but are not limited to, ethyl acrylate, ethyl acrylate/methyl methacrylate copolymer, and n-butyl acrylate/acrylonitrile/methacrylic acid.

According to the present invention, the stability-enhanced gelatin-based layers provided herein will typically contain between about 0.1 and about 2.0, and preferably between about 0.4 and about 1.5, and more preferably between about 0.75 and about 1.0, parts by weight of the SEA per each part gelatin. In embodiments wherein the subbing layer comprises a gelled network of inorganic particles and an ambifunctional silane as described above, the SEGBL may achieve the advantageous benefits of the present invention when containing as little as 0.1 parts by weight of SEA per 1 part of gelatin. In embodiments comprising other types of subbing layers, the SEGBL typically comprises at least about 0.2 parts by weight SEA per 1 part gelatin to achieve the advantageous results of the invention. SEGBLs with ratios substantially below the indicated range may tend to not achieve the desired increased adhesion which is provided by the present invention. SEGBLs containing substantially larger amounts of the aforementioned SEA may approach a maximum level of benefit beyond which no appreciable further increase in adhesion is observed. Furthermore, increasing proportion of SEA tends to increase the viscosity of the coating composition of the SEGBL, and may thereby make it more difficult to handle. The gelatin and SEA are preferably substantially dispersed with each other so as to most effectively achieve the advantages of this invention uniformly throughout the SEGBL.

A SEGBL may also optionally further comprise one or more particulate materials, hardeners, and/or wetting agents.

A particulate material or roughening agent may be used to impart a somewhat roughened texture to the surface of the SEGBL which is also typically in turn imparted to the ultimate surface of an overlying radiation-sensitive emulsion and optional top coat. This roughness is believed to improve the inking and printing characteristics of the resultant printing plate, and may also tend to improve the adhesion of subsequent layers or coatings of the lithographic element to each other. Some illustrative examples of roughening agents include particulate silicas such as CABO-SIL from Cabot Company and SYLOID from W.R. Grace Company.

Hardening agents useful in a SEGBL include, but are not limited to, chrome alum, glyoxal, or formaldehyde or other vinyl-type agents. Formaldehyde is typically preferred. The optimum amount of hardening agent needed to provide desired characteristics and hardness may be readily determined by trial and error.

One or more wetting agents may be incorporated to improve the coating characteristics of the coating composition. Examples of wetting agents include, but are not limited to, the TRITON series from Rohm and Haas Company, TERGITOL from Union Carbide Corporation, and NEKAL from GAF Chemicals Corporation, DUPONOL series from E. I. du Pont de Nemours and Company, and AEROSOL from American Cyanamid Company. The amount of wetting agent which is needed will depend in part upon the wetting agent or agents selected, their effect upon and compatibility with the other components of the stability-enhanced gelatin-based layer, and the coating techniques employed, and may be readily determined by trial and error.

In the event the SEGBL is intended to serve as an antihalation layer, it further comprises a light absorbing material dispersed therein. The light absorbing material is commonly carbon black although other known antihalation agents such as organic dyes may be used. The amount of antihalation agent used will depend in part upon the agent or agents selected and the thickness of the SEGBL, and may be readily determined by trial and error.

An unexpected advantage of the present invention is that the adhesion of gelatin-based antihalation layers containing carbon black to subbing layers containing a gelled network of inorganic particles and an ambifunctional silane, such as described above, is improved by incorporation of a SEA in the antihalation layer in accordance herewith. While I do not wish to be bound by this theory, it is believed that the SEA,

particularly those wherein $R^3$ (Formula II above) is a hydrogen, e.g., methacrylic acid, bond to the silane functionality of the subbing layer, thereby tending to overcome the anti-adhesive effects of the surfactants in the carbon black dispersion.

Stability-enhanced gelatin-based layers of the invention may be coated on the surface of the subbing layer by known techniques, e.g., dip coating, knife coating, roller coating, or slot coating, from aqueous or organic solvent solutions and then dried.

Radiation-sensitive silver halide emulsions useful in the present invention include those which comprise silver halide grains dispersed in a hydrophilic colloid such as gelatin. As mentioned above, in some instances the aforedescribed SEGBL may serve as the radiation-sensitive emulsion in which event it will further comprise the silver halide grains and sensitizing agents discussed below. In such embodiments, however, the light absorbing agents discussed above will be omitted. In other embodiments, the radiation-sensitive emulsion will be another coating which is adhered over the aforedescribed SEGBL.

The radiation-sensitive emulsion layer may comprise any type of photographic silver halide which can be used in a DT, i.e, silver salt diffusion transfer type, development process, including, but not limited to, silver chloride, silver bromide, silver chlorobromide, silver iodobromide, silver iodochloride, or silver iodochlorobromide. Typically, the preferred emulsion is a high contrast sensitive silver chlorobromide emulsion wherein the silver halide is about 75 mole percent chloride and about 25 mole percent bromide.

Either negative-type or direct-positive silver halide emulsions may be used with the present invention.

The crystalline form of the silver halide grains has no limitation and the grains may be monodispersed or polydispersed grains and furthermore, may be core-shell type grains or tablet grains.

As is known in the art, the silver halide grains may contain heavy metals such as rhodium salts, iridium salts, palladium salts, ruthenium salts, copper salts, etc. to control contrast and reciprocity failure.

As known to those skilled in the art, silver halide grains may be sensitized by various techniques at the time of preparation or coating. For example, silver halide grains may be chemically sensitized by well known methods such as with sodium thiosulfate or alkyl thiourea, and/or gold compounds such as gold rhodanate and gold chloride.

As desired, silver halide grains used in plates of this invention may be sensitized or desensitized to many different wavelengths and wavelength ranges in accordance with techniques known in the art. Thus, in plates of the invention, the silver halide grains may be orthochromatically or panchromatically sensitized, and may be sensitized for exposure by, for instance, helium-neon laser, argon laser, light-emitting-diode, semiconductor laser beam, visible light, or ultraviolet light. If desired the silver halide grains may be desensitized to certain wavelengths and sensitized to others, e.g., desensitized to the visible light but sensitized to ultraviolet radiation to permit handling under ordinary room light. Silver halide grains may be positively or negatively sensitized or desensitized with organic sensitizing dyes such as cyanine or hemicyanine dyes. U.S. Patent No. 4,134,769 (Yoshida et al.) discloses some illustrative examples of sensitizing dyes that may be used on printing plates of the invention.

The radiation-sensitive emulsion layer of printing plates of the invention may also contain plasticizers, hardening agents, wetting agents, fog inhibitors, stabilizers, matting agents, developing agents, and other adjuvants as will be understood by those skilled in the art.

Printing plates of the invention will typically further comprise, over the radiation-sensitive emulsion, an optional silver salt diffusion transfer receptor layer for formation of the ink receptive image. The aforementioned U.S. Patent No. 4,361,635, which is incorporated herein by reference, discloses a silver-receptive polyaldehyde-containing receptor layer which may be used on elements of the invention.

Printing plates of the present invention may be made by imagewise exposing the aforedescribed printing plate elements having radiation-sensitive emulsions and then developing by silver salt diffusion transfer. Following exposure, the plates may be developed or processed in diffusion transfer type developers, e.g., 3M ONYX Brand Plate Developer. In accordance with the invention, the interlayer adhesion of such printing plates will remain high in spite of the typically high pH of such developers and other rigorous conditions to which such printing plates are typically exposed. Printing may then be achieved by mounting the thusly made plate on a printing press and carrying out printing in the usual lithographic manner.

## Examples

The invention will be further explained by the following illustrative examples which are intended to be nonlimiting. Unless otherwise indicated, all amounts are expressed in parts by weight.

The following test methods were used in the Examples.

Taber Abrasion

Resistance to abrasion was tested by preparing a plate sample as indicated below and punching four circular disks from the completed element with a circular die. Each sample was individually placed on a Taber Abraser equipped with No. RS-10 rubber wheels and no counterweights. Fresh SCOTCH Brand Double Stick Tape No. 665 from 3M was wrapped completely around the wheels of the Taber Abraser oriented such that the outside side of the tape as it came off the roll was in contact with the plate material being tested for each sample. In some instances as indicated, the plate was scribed in a grid pattern down to the film base to increase any tendency for the layers of the plate material to separate. One drop of water was placed on the dry sample, the wheels of the Taber Abraser gently contacted to the surface of the sample, and then the Abraser run for 100 cycles. The samples were then examined visually to determine degree of abrasion.

Reversed Blanket Impact

Samples of plate materials being tested were exposed and processed in a 3M Camera Processor to provide an open step 3 and solid step 4 gray scale. A MERCURY RAPID 5050 Special 4 ply Rubber Offset Blanket, available from Rapid Roller Co. was mounted fabric-side-in (toward cylinder)/rubber-side-out on a Heidelberg GTO Printing Press and packed to a blanket plus packing thickness of 0.115 inch (2.9 millimeters) for 7 mil (180 micron) plate samples and 0.118 inch (3.0 millimeters) for 4 mil (100 micron) plate samples. Ink form bands were set at 1/8 inch (3.2 millimeters) and dampener form pressure was set at 0.004 inch (0.1 millimeter). Samples of the plate material being tested were mounted on the press, starter solution applied with a cotton wipe, the press run for ten revolutions down, and then the press put on impression and feed paper supplied for a run of about 1000 copies to check that the plate was printing. The blanket was then reversed, i.e., fabric side toward the plate and away from the cylinder, to increase the abrasive impact on the plate, plates cleaned with blanket wash solution, and then the press run for about 1000-2000 impressions. The blanket was then reversed to its original orientation and the press run again to check print quality. The plates and images produced therewith were then examined by hand to evaluate performance of the samples.

Examples 1-5 and Comparative Examples A-E

In Examples 1-2 and Comparative Examples A-B, 4 mil polyester film base was primed with polyvinylidine chloride and subbed with a gelled network of inorganic particles containing an adhesion-promoting amount of an ambifunctional silane. In Example 3 and Comparative Example C, 7 mil polyester base was used.

In Example 5 and Comparative Example E, 4 mil (100 micron) polyester film base was primed as in Example 1 and a conventional subbing layer comprising gelatin, water, and wetting agents was applied thereover. In Example 4 and Comparative Example D, a polystyrene film base was used without being primed but with a gelatin-containing subbing layer.

A stability-enhanced gelatin-based antihalation coating was then prepared as follows. First the following components

| Parts | Component |
|---|---|
| 76.0 | Water, |
| 4.0 | TINTAYD WD2350-carbon black, available from Daniel Products Company, |
| 8.0 | Potassium Hydroxide-1 normal aqueous solution, |
| 12.0 | SYLOID 74-silica available from Davison Division of W.R. Grace, |

were ball milled to form a dispersion. This dispersion was then used in Examples 1-5 to formulate an antihalation layer coating composition with the following:

| Parts | Component |
|---|---|
| 16.7 | Dispersion from above, |
| 47.9 | Water, |
| 15.0 | SEA-butyl acrylonitrile methacrylic acid polymer, 20% aqueous dispersion, |
| 4.0 | Gelatin, |
| 2.0 | TRITON X-200-wetting agent available from Rohm & Haas, 25% aqueous solution, |
| 0.14 | Phosphoric acid, 2 molar, |
| 8.64 | Hydroquinone, 4% aqueous solution, |
| 0.23 | Phenidone, 4% solution in methanol, |
| 5.4 | Formaldehyde, 3.7% aqueous solution. |

The water was heated to about 105° F (40° C) and the gelatin dissolved therein. The remaining components were then added and the solution mixed mixed well. The solution, which had a SEA-to-gelatin weight ratio of about 0.75:1, was then extrusion coated onto the base, subbed as indicated, at a rate of about 40 milliliters per meter$^2$.

In Comparative Examples A-E, the antihalation layer coating composition was made in the same manner except the stability-enhancing butyl acrylonitrile methacrylic acid was omitted and an additional amount of water equivalent in weight was used in place thereof.

A conventional chlorobromide photographic emulsion containing about 25 weight percent silver bromide and about 75 weight percent silver chloride was used. The emulsion, which had a gelatin to silver weight ratio of about 1.77:1 was coated via extrusion coating at a silver coating weight of about 0.6 grams per square meter.

A receptor layer was formed as follows. A palladium sol was formed by adding, while rapidly stirring, to 929 parts of water, the following: (1) 8 parts of a 1 percent by weight solution of palladium chloride in 2 percent nitric acid solution; (2) 3.8 parts of a 10 percent by weight solution of DAXAD 11, from W. R. Grace Company; (3) 5.7 parts of a 0.2 percent by weight aqueous solution of potassium borohydride; (4) 13.4 parts of a 10 percent by weight aqueous solution of TRITON X-100 surfactant, from Rohm and Haas Company; and (5) 40 parts of a 4 percent by weight solution of SUM STAR 190 dialdehyde starch, from Hexel Chemical Company, in a 1 percent by weight aqueous solution of sodium acetate. The resulting palladium sol was then extrusion coated on the dry emulsion layer at a rate of about 10 grams per square meter.

In each Example and Comparative Example, the plate material was fully exposed and then developed by treating for about 30 seconds in 3M ONYX Brand Plate Developer which has a pH of about 13.5, rinsing with tap water, and then allowing to dry.

The Taber Abrasion results were as follows.

| Exam. | Base | Sub | Adhesion |
|---|---|---|---|
| 1 | Polyester | Silane[1] | Excellent |
| A | Polyester | Silane[1] | Fail |
| 2 | Polyester | Silane[1] | Excellent |
| B | Polyester | Silane[1] | Fail |
| 3 | Polyester | Silane[1] | Excellent |
| C | Polyester | Silane[1] | Fail |
| 4 | Polystyrene | Gelatin[2] | Excellent |
| D | Polystyrene | Gelatin[2] | Fair |
| 5 | Polyester | Gelatin[2] | Marginal |
| E | Polyester | Gelatin[2] | Fair |

1 Gelled network of inorganic particles containing an adhesion-promoting effective amount of an ambifunctional silane.

2 Conventional subbing comprising gelatin, water, wetting agent, and hardener.

These results illustrate the improved interlayer adhesion achieved in lithographic printing plates of the

invention.

Examples 6-9 And Comparative Examples F And G

Examples 6-9 illustrate printing plates of the invention wherein the stability-enhanced gelatin-based antihalation layers contain varying ratios of SEA and gelatin in accordance with the present invention.

In Examples 6-8 plates were made as in Example 5. In Comparative Example F, a plate was made as in Comparative Example E. In Example 9 and Comparative Example G, plates were made as in Example 5 and Comparative Example E, respectively, using 7 mil (180 micron) polyester X-RAY Base from Du Pont instead of the film base and prime and subbing layers described above.

After being exposed and processed with a test pattern of varying gray scale steps, and then developed as in Examples 1-5, the interlayer adhesion of the plates was evaluated via the Reversed Blanket Impact test.

The results and relative amounts of SEA and gelatin were as follows:

| Example | Ratio[1] | Result |
|---|---|---|
| 6 | 1:1 | Minimal spots of delamination |
| 7 | 0.5:1 | Minimal spots of delamination |
| 8 | 2:1 | Slight spotting due to delamination |
| F | 0:1 | Large spots of delamination |
| 9 | 1:1 | Good print quality without delamination |
| G | 0:1 | Severe spotting density, substantially unreadable print quality |

1 Weight ratio of butylacrylonitrile methacrylic acid to gelatin.

Examples 10-21 And Comparative Examples H-J

Examples 10-21 and Comparative Examples H-J further illustrate the efficacy of the invention at varying ratios of SEA to gelatin in the SEGBL.

In Examples 10-15, standard 4 mil polyester base with an acrylate prime and gelatin subbing was used to make a plate as in Example 1, except the ratio of SEA and gelatin was adjusted as indicated to the indicated ratio by altering the amounts of SEA dispersion and water used to a constant total of 62.9 parts. Comparative Example H was a similar plate made with a silane subbing as in Example 1 substituting an equivalent amount of water for the SEA dispersion.

In Examples 16-21, plates were made as in Examples 10-15 except a polyvinylidine chloride prime and silane subbing were used as in Example 1. Comparative Example J was a similar plate made with a gelatin subbing and substituting an equivalent amount of water for the SEA dispersion. Comparative Example I was a similar plate to Comparative Example J, except an acrylate prime was used instead of a polyvinylidine chloride prime.

After being developed as in Example 1, Taber Abrasion testing was done on the samples. The results were as follows:

| Example | Prime | Ratio | Adhesion |
|---|---|---|---|
| 10 | Acrylate | 0.2:1 | Fair |
| 11 | Acrylate | 0.4:1 | Very Good |
| 12 | Acrylate | 0.6:1 | Excellent |
| 13 | Acrylate | 0.8:1 | Excellent |
| 14 | Acrylate | 1:1 | Excellent |
| 15 | Acrylate | 1.5:1 | Excellent |
| H | Acrylate | 0:1 | Poor |
| 16 | PVDC | 0.2:1 | Very Poor |
| 17 | PVDC | 0.4:1 | Fair |
| 18 | PVDC | 0.6:1 | Excellent |
| 19 | PVDC | 0.8:1 | Excellent |
| 20 | PVDC | 1:1 | Excellent |
| 21 | PVDC | 1.5:1 | Excellent |
| I | PVDC | 0:1 | Good-picking (gelatin subb) |
| J | PVDC | 0:1 | Fail (silane subb) |

Various modifications and alterations of this invention will become apparent to those skilled in the art without departing from the scope and spirit of this invention.

## Claims

1. A silver salt diffusion transfer type lithographic printing plate element characterized in that said element comprises (1) a film support having at least one optionally primed polymeric surface to which is adhered (2) a subbing layer, and (3) adhered to said subbing layer, a stability-enhanced gelatin-based layer comprising gelatin and a stability-enhancing polymer or copolymer having the formula:

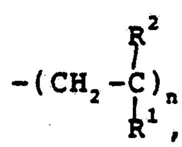

wherein $R^1$ is a hydrogen or methyl; and $R^2$ is a nitrilo, i.e., -CN, or group having the formula:

$$-\overset{O}{\overset{\|}{C}}-O-R^3,$$

wherein $R^3$ is a hydrogen or an alkyl having from 1 to 4 carbon atoms, said gelatin and said stability-enhancing polymer or copolymer being substantially uniformly dispersed with each other.

2. The element of claim 1 further characterized in that said stability-enhancing polymer or copolymer is at least one of the following: ethyl acrylate, ethyl acrylate/methyl methacrylate copolymer, or n-butyl acrylate/acrylonitrile/methacrylic acid.

3. The element of claim 1 further characterized in that said stability-enhancing copolymer is butyl acrylonitrile methacrylic acid.

4. The element of any one of claims 1-3 further characterized in that said stability-enhanced gelatin-based layer comprises between about 0.1 and about 2.0 parts by weight of said stability-enhancing polymer or copolymer per 1.0 part by weight of said gelatin.

5. The element of any one of claims 1-3 further characterized in that said stability-enhanced gelatin-based layer comprises between about 0.4 and about 1.5 parts by weight of said stability-enhancing polymer or copolymer per 1.0 part by weight of said gelatin.

6. The element of any one of claims 1-3 further characterized in that said stability-enhanced gelatin-based layer comprises between about 0.75 and about 1.0 parts by weight of said stability-enhancing polymer or copolymer per 1.0 part by weight of said gelatin.

7. The element of any one of claims 1-6 further characterized in at least one of the following:

(1) said subbing layer is a gelled network of inorganic particles containing an adhesion-promoting effective amount of an ambifunctional silane; or

(2) said subbing layer comprises gelatin.

8. The element of any one of claims 1-7 further characterized in that said stability-enhanced gelatin-based layer is radiation-sensitive and comprises grains of silver halide.

9. The element of any one of claims 1-8 further characterized in at least one of the following:

(1) said element further comprises over said stability-enhanced gelatin-based layer, a radiation-sensitive emulsion layer which comprises silver halide grains;

(2) the halide portion said emulsion layer comprises about 75 mole percent silver chloride and about 25 mole percent silver bromide; or

(3) said element further comprises a silver salt diffusion transfer receptor layer over said emulsion layer.

10. The element of any one of claims 1-9 further characterized in that said element further comprises one or more other layers over said stability-enhanced gelatin-based layer wherein one or more of said other layers contain gelatin and are substantially free of said stability-enhancing polymers or copolymers.

11. A method of making a lithographic printing plate characterized in that said method comprises (1) imagewise exposing a printing plate element of claim 1 wherein said stability-enhanced gelatin-based layer is radiation-sensitive and comprises grains of silver halide, or wherein said element further comprises a radiation-sensitive emulsion layer comprising silver halide grains over said stability-enhanced gelatin-based coating, and (2) developing said plate in a silver salt diffusion transfer process.

12. A method of printing characterized in that said method comprises mounting a lithographic printing plate made by the method of claim 11 on a printing press and carrying out printing.

European Patent Office

# EUROPEAN SEARCH REPORT

Application Number

EP 89 31 2105

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 062 674 (R.C. HOUCK et al.) * Column 1, line 64 - column 2, line 25; column 3, lines 14-29,51-60; column 3, line 75 - column 4, line 9; examples H,I,J; example VIII; claim 1 * --- | 1-2,4-6,8,10 | G 03 C 1/93<br>G 03 F 7/07 |
| X | US-A-2 331 717 (G.F. NADEAU et al.) * Page 1, column 2, line 46 - page 2, column 1, line 7; claim 1 * --- | 1-2,4-6,10 | |
| X | GB-A- 562 666 (J. HALDEN AND CO. LTD) * Page 2, column 1, lines 58-60; page 2, column 2, lines 79-95,115-124; claims 1-3 * --- | 1-2,4-6,10 | |
| A | EP-A-0 066 100 (3M) * Page 9, lines 1-20; claim 1 * --- | | |
| A | US-A-2 360 216 (M.F. FILLIUS) * Whole document * --- | | TECHNICAL FIELDS SEARCHED (Int. Cl.5) |
| A | US-A-3 885 081 (A.J.V. PAESCHEN et al.) * Abstract; column 4, lines 58-63; column 15, lines 10-24 * ----- | | G 03 C 1/00<br>G 03 F 7/00 |

The present search report has been drawn up for all claims

| Place of search | Date of completion of the search | Examiner |
|---|---|---|
| THE HAGUE | 12-02-1990 | BOLGER W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document